# EUROPÄISCHE PATENTSCHRIFT

(11) **EP 1 145 253 B1**
(45) Veröffentlichungstag und Bekanntmachung des Hinweises auf die Patenterteilung: **22.11.2006**
(21) Anmeldenummer: 99939382.0
(22) Anmeldetag: 16.07.1999
(51) Int. Cl.: H01L 39/14

(54) **GESCHÜTZTES SUPRALEITENDES BAUTEIL UND VERFAHREN ZU DESSEN HERSTELLUNG**
PROTECTED SUPERCONDUCTING COMPONENT AND METHOD FOR PRODUCING THE SAME
COMPOSANT SUPRACONDUCTEUR PROTEGE ET SON PROCEDE DE PRODUCTION

(30) Priorität: 05.08.1998 DE 19835454
(43) Veröffentlichungstag der Anmeldung: 17.10.2001
(73) Patentinhaber: Nexans SuperConductors GmbH, 50351 Huerth (DE)
(72) Erfinder: GAUSS, Stephan, D-65843 Sulzbach (DE); BOCK, Joachim, D-50374 Erftstadt (DE); HOLZEM, Johannes, D-50354 Hürth (DE); BROMMER, Günter, D-65185 Wiesbaden (DE); GROM, Markus, D-61476 Kronberg (DE); HORST, Werner, D-50321 Brühl (DE)
(74) Vertreter: Feray, Valérie
(86) Internationale Anmeldenummer: PCT/EP1999/005099
(87) Internationale Veröffentlichungsnummer: WO 2000/008657

(56) Entgegenhaltungen:
- EP-A- 0 525 385

## Beschreibung

Die Erfindung betrifft ein bei hochtemperatursupraleitendes Bauteil mit einer bestimmten Querschnittsfläche, das einen Stromführungsabschnitt aufweist, wobei der Stromführungsabschnitt in einem Sicherungsbereich derart mit einem Sicherungsleiter in Kontakt steht, daß der beim Übergang des Supraleiters zur Normalleitung fließende Strom im Sicherungsbereich vom Sicherungsleiter während mindestens 1 Sekunde zerstörungsfrei aufgenommen und weitergeleitet werden kann, sowie ein Verfahren zu dessen Herstellung.

Mit der Entdeckung eines keramischen Materials, das bei einer vergleichsweise hohen Temperatur das Phänomen der Supraleitung zeigt, gelang Bednorz und Müller (Z. Phys. B. 64, 189 (1986)) die erste große Verbesserung der Übergangstemperatur zur Supraleitung in den 80er Jahren. Das von Bednorz und Müller eingesetzte Material wies eine nominale Zusammensetzung La₂₋ₓMₓCuO_{y} auf, worin M für Calcium, Barium oder Strontium stand, x sich typischerweise um Werte zwischen 0 und 0,3 bewegte und y von den Herstellungsbedingungen abhängig war. Die höchste Übergangstemperatur zur Supraleitung wurde bei Materialien gemessen, bei denen M für Strontium stand und x für etwa 0,15 bis 0,20 stand. Diese Materialien wiesen eine Übergangstemperatur im Bereich zwischen etwa 40 und etwa 50 K auf (Cava et al., Phys. Rev. Letters, 58, 408 (1987)). Im März 1987 berichteten Chu et al., Phys. Rev. Letters, 58, 405 (1987), daß ein Material der Zusammensetzung Y_{1,2}Ba_{0,8}CuO_{y} eine Übergangstemperatur zur Supraleitung zeigt, die zwischen etwa 90 und 100 K lag.

Seit diesen Entdeckungen wurden eine weitere Reihe von Materialien aufgefunden, die Supraleitung bei Temperaturen zeigen, die oberhalb des Siedepunkts von flüssigem Stickstoff liegen. Mit diesen Entdeckungen gelang damit der Supraleitertechnologie ein Sprung hin zu breiteren Anwendungen, da widerstandslose Stromleitung nun nicht mehr ausschließlich von extrem teuerer und anfälliger Kühlung des supraleitenden Materials mit flüssigem Helium (Siedepunkt: 4 K) abhing, sondern bereits mit dem wesentlich billigeren flüssigen Stickstoff bei einer entsprechend höheren Temperatur erzielt werden konnte.

Nachteilig wirkte sich bei den neu aufgefundenen Materialien jedoch aus, daß es sich um keramische Materialien handelte, die konventionellen Verarbeitungsmethoden für "Leiter" nicht zugänglich waren. Die keramischen Supraleiter wiesen keinerlei Flexibilität oder Duktilität auf, waren spröde und nicht formbar. Eine formgebende Bearbeitung dieser Materialien mußte daher in der Regel mit teueren Diamantschneidewerkzeugen unter großem Aufwand vorgenommen werden.

Dies anderte sich zumindest teilweise mit der Einführung des sogenannten Schmelzgußverfahrens. Mit diesem Verfahren, das in der EP-B 0 462 409 beschrieben ist, eröffnete sich die Möglichkeit, beispielsweise zylindrische Hohlformen unterschiedlicher Abmessungen, beispielsweise dickwandige Rohre mit vergleichsweise kleinem Durchmesser und größerer Länge, wie sie in der Hochstromtechnik Anwendung finden konnten, herzustellen.

Mit zunehmendem Verständnis der bei Supraleitung auftretenden Phänomene sowie einer Weiterentwicklung der Verarbeitungstechnik der keramischen Supraleiter wurden Verfahren entwickelt, die es ermöglichen, das keramische Hochtemperatursuprateitermaterial zu flexiblen Drähten oder Bändern zu verarbeiten, um eine wenigstens Normalleitern annähernd gleichende Einsatzmöglichkeit für hochtemperatursupraleitende Materialien zu eröffnen. So wird beispielsweise in *IEEE Transactions on Magnetics, Bd. 25, Nr. 2, März 1989* beschrieben, daß sich Bänder aus supraleitendem Material in Form von silberummantelten Drähten erhalten lassen. Hierzu werden die entsprechenden zu Supraleitern führenden Materialien beispielsweise vermischt, calciniert und gesintert und anschließend in eine Silberröhre verfüllt. Durch Zugbehandlung wird der Durchmesser der Silberröhren schrittweise verringert, bis ein Draht oder ein dünnes Band entsteht, das entsprechend flexibel verarbeitbar ist. Die so erhältlichen Drähte und Bänder werden in der Regel noch nachbehandelt, um die erforderlichen supraleitenden Eigenschaften herzustellen oder zu optimieren. Gegebenenfalls kann bei bestimmten Arten von Hochtemperatursupraleitern auch schon supraleitendes Pulver in die entsprechenden Silberröhren verfüllt und anschließend zu Bändern oder Drähten weiterverarbeitet werden. Diese Methode ist allgemein als Powder-In-Tube-Methode (PIT) bekannt. In solchen draht- oder bandförmigen Hochtemperatursupraleitern liegt das supraleitende Material in Form supraleitender "Körner" vor. Während der Strom innerhalb der Kömer sehr gut fließen kann, ist der Stromfluß von Korn zu Korn jedoch lediglich entlang der Komgrenzen möglich, die schlechtere supraleitende Eigenschaften aufweisen als die Körner selbst. Die Komgrenzen werden daher in der Regel als "weak links" bezeichnet. Ein weiterer Nachteil solcher Draht- oder Bandsysteme besteht darin, daß die zusammenhängenden Querschnittsflächen des hochtemperatursupraleitenden Materials sehr gering sind. Übliche Drähte oder Bänder weisen beispielsweise eine Querschnittsfläche von etwa 0,4 mm² auf, wovon in der Regel nur etwa 30 % auf hochtemperatursupraleitendes Material entfallen. Es liegt daher auf der Hand, daß mit solchen Systemen zu erzielende kritische Ströme stark limitiert sind und für viele Anwendungen nicht ausreichen.

Die Verwendung von Silber im Zusammenhang mit Hochtemperatursupraleitern beschreiben beispielsweise M. Itoh, H. Ishigaki, T. Ohyama, T. Minemoto, H. Noijiri und M. Motokawa in *J. Mater. Res., Bd. 6, 11, November 1991*. Es wurde gezeigt, daß ein Anteil an Silberpulver die elektrischen Eigenschaften eines hochtemperatursupraleitenden Materials, im vorliegenden Fall auf Basis von Y, Ba, Cu und O verbessert. Die Autoren beschreiben Hochtemperatursupraleiter mit einem Anteil von bis zu 28 Gew.-% in Pulverform.

Eine bereits weitgehend etablierte und gut untersuchte Einsatzmöglichkeit für röhrenförmige Bauteile aus hochtemperatursupraleitendem Material stellt die induktive Strombegrenzung dar. So beschreibt beispielsweise die US-A 5,140,290 eine Vorrichtung zur induktiven Strombegrenzung eines Wechselstroms, bei welcher der zu begrenzende Strom durch eine Induktionsspule fließt. Im Inneren dieser Spule ist ein Hohlzylinder aus einem Hochtemperatursupraleiter angeordnet und konzentrisch darin ein weichmagnetischer Werkstoff hoher Permeabilität. Bei Normalbetrieb bzw. Nennstrom schirmt die Supraleitfähigkeit des Hohlzylinders dessen Innenraum ab, so daß die Impedanz der Induktionsspule sehr gering ist. Der Strom fließt dabei im Hohlzylinder kreisförmig, ein Stromfluß entlang der Längsachse des Hohlzylinders findet nicht statt.
Bei einem Überstrom, z. B. durch einen Netzkurzschluß, verschwindet die Supraleitfähigkeit, und die Impedanz der Induktionsspule erreicht ihren maximalen strombegrenzenden Wert. Eine solche Spannungs- und Strombelastung bei kurzzeitigen Überströmen oberhalb des kritischen Stroms und mit elektrischen Spannungen von einigen mV/cm bis V/cm führen zu sogenannten "heißen" Stellen. Durch kleine Inhomogenitäten im Werkstoff des Hochtemperatursupraleiters kommt es zu lokalen Überhöhungen der elektrischen Spannung. Diese führen zu einer verstärkten Energiedissipation und damit zu einer Aufwärmung an dieser Stelle. Die Folge ist eine zunehmende lokale Überhöhung des Widerstandes und damit Erzeugung eines Spannungsabfalls. Bei längerer Belastung führt ein solcher Effekt zur örtlichen Zerstörung des Hochtemperatursupraleiters.

Solche "heißen" Stellen treten routinemäßig in hochtemperatursupraleitenden Werkstoffen auf, da bei der Herstellung eines solchen Materials Qualitätsschwankungen entlang des Hochtemperatursupraleiters entstehen können, die eine geringere Stromtragfähigkeit aufweisen. "Heiße" Stellen weisen in der Regel eine geringe Ausdehnung von etwa 0,01 bis 0,5 mm auf. Die entstehenden Überströme sind außerordentlich kurzzeitig und bewegen sich in Zeiträumen von etwa 10 bis 100 ms.

Zur Stabilisierung eines solchen Bauteils schlägt die DE-A 44 18 050 vor, auf der Oberfläche des Supraleiters eine etwa 1 bis 10 µm dicke Silberschicht aufzubringen. Zur mechanischen Stabilisierung des Supraleiters wird eine elastische Stahldrahtwicklung vorgeschlagen, die mit Lot oder einem kältebeständigen Kunstharz derart fixiert wird, daß eine Gesamtzugspannung der so erhältlichen Armierung bzw. ein kompressiver Druck auf den supraleitenden Hohlzylinder auch bei weniger als 100 K bestehen bleibt.

Demgemäß beschreibt die EP-A 0 822 560 ebenfalls eine rohrförmige Hochtemperatursupraleiteranordnung, die zur induktiven Strombegrenzung eingesetzt wird. Die Druckschrift führt an, daß bei einem Kurzschlußstrom in einem Hochtemperatursupraleiter in diesem Vibrationen auftreten, die ohne Schutzmaßnahmen zu einer Rißbildung der hochtemperatursupraleitenden Keramik führen können. Um eine Rißbildung zu verhindern, wird der Hochtemperatursupraleiter mit einem Stützwickel aus einem Faserverbundwerkstoff umwickelt, wodurch Zug- und Druckspannungen gleichmäßiger verteilt werden. Um einen solchen Stützwickel kann eine Dämpfungsschicht aus schwingungsdämpfender Watte oder Filz angebracht sein. Weiterhin wird beschrieben, daß auf der Oberfläche des Hochtemperatursupraleiters eine normalleitende, metallische, elektrische Stabilisierungsschicht aufgebracht. Hierbei handelt es sich um eine etwa 1 µm dicke Metallschicht, vorzugsweise eine Silberschicht, die mit einer mechanischen Armierung, vorzugsweise aus Stahldraht, gewickelt und mit einem leitenden Fixiermittel fixiert ist.

Die EP-B 0 731 986 beschreibt ebenfalls eine Vorrichtung zur Strombegrenzung, die zur resistiven Begrenzung von sowohl Gleich- als auch Wechselströmen geeignet ist. Beschrieben wird ein schichtförmiger Verbundaufbau aus Supraleitern und Normalleitern, wobei die Schichtdicke des Normalleiters so gewählt werden soll, daß der elektrische Widerstand dieser Schicht etwa gleich groß ist wie derjenige der Schicht des angrenzenden Supraleiters im nichtsupraleitenden Zustand.

Neben der Anwendung als Strombegrenzer lassen sich hochtemperatursupraleitende Bauteile sowohl in röhrenförmiger als auch in massiver Ausgestaltung als Stromzuführungen für Hochtemperatursupraleiteranwendungen einsetzen. Solche Stromzuführungen aus hochtemperatursupraleitendem Material finden beispielsweise ihre Anwendung als Stromzuführungen für supraleitende Magnete in Kemspintomographen oder -spektrometern, in Beschleunigermagneten oder in Forschungsmagneten. Hier stellen sie in der Regel die elektrische Verbindung zwischen einem 4 K-Temperaturniveau und einem 77 K-Temperatumiveau dar. Da supraleitende Magneten in der Regel mit flüssigem Helium gekühlt werden, ist es von großer Bedeutung, daß die Stromzuführung solcher Magneten nur eine geringe Wärmeleitfähigkeit aufweist, da, wie bereits eingangs erwähnt, eine Abkühlung auf 4 K nur mit flüssigem Helium erreicht werden kann, das zum einen teuer ist und zum anderen empfindliche und komplexe Kühlapparaturen benötigt. Eine Stromzuführung soll daher prinzipiell eine geringe Wärmeleitfähigkeit aufweisen, um das Kühlaggregat zu schonen und die Kühlkosten gering zu halten.

Supraleitende Spulen zur Erzeugung starker Magnetfelder bedürfen in der Regel eines besonderen Schutzes. Selbst bei Verwendung stabilisierten Materials und fehlerfreier Konstruktion der Spule können Ursachen eintreten (z.B. bei einem Gaseinbruch in das Kryostatenvakuum), die dazu führen, daß die Spule normalleitend wird. Dabei bricht das Magnetfeld zusammen und die gesamte im Magnetfeld gespeicherte Energie wird in Wärme umgesetzt. Bei großen Spulen ist diese Energie sehr beachtlich. Ein Magnetfeld von 5 T in einem Raum von 1 m³ enthält eine gespeicherte Feldenergie von 10⁷ Ws (ca. 2,8 kWh). Wenn diese Energie beim Eintritt der Normalleitung unkontrolliert schnell in Wärme umgewandelt wird, kann dies zur völligen Zerstörung des Magneten führen.

Dabei können verschiedene Prozesse ablaufen. Ist der elektrische Widerstand der Spule im normalleitenden Zustand groß, so werden zwar die auftretenden Ströme klein bleiben, so daß eine Zerstörung durch Stromheizung vermieden wird. In diesem Fall werden aber während des Feldzerfalls sehr große Spannungen auftreten, die zu Spannungsüberschlägen zwischen den Windungen der Spule führen können. Um solche katastrophalen Folgen eines unbeabsichtigten Übergangs der Spule in die Normalleitung zu vermeiden, werden beispielsweise bei großen Spulen Schutzvorrichtungen vorgeschlagen, die geeignet sind, die gespeicherte Energie möglichst rasch aus der Magnetspule auszukoppeln. Hierzu wird in *Supraleitung, 4. Aufl., VCH Weinheim, Wemer Buckel , 1990* auf Seite 242 vorgeschlagen, die Spule mit einem Außenwiderstand zu verbinden, der beim Feldzerfall den überwiegenden Teil der gespeicherten Energie in Wärme verwandelt. Innere Überschläge werden dadurch nicht oder nicht ausreichend vermieden. Eine weitere Möglichkeit besteht darin, die gespeicherte Energie induktiv aus der Magnetspule auszukoppeln, indem die Spule mit einem geschlossenen Leiter kleiner Selbstinduktion umgeben wird. Bei diesem Verfahren wird allerdings die gesamte Energie an das Bad aus flüssigem Helium abgegeben, was unter Umständen zu einer explosionsartigen Verdampfung führen kann.

Die EP-A 0 837 478 beschreibt eine Stromzuführung für ein supraleitendes Magnetsystem, die kein flüssiges Helium benötigt. Beschrieben wird ein röhrenförmiges Stromzuführungselement aus hochtemperatursupraleitendem Material, das an jedem Ende eine Elektrode aufweist. Das Stromführungselement überbrückt einen Temperaturgegensatz zwischen einem äußeren Temperatumiveau, das eine Temperatur von etwa 77 K aufweist und einem inneren Temperatumiveau, das eine Temperatur von etwa 4 K aufweist. Beschrieben wird die vorteilhafte geringe Leitfähigkeit einer solchen Stromzuführung, die lediglich einen geringen Wärmeübergang aus dem wärmeren in das kältere Niveau zuläßt und damit den Kühlaufwand für das kältere Temperatumiveau im Vergleich zu normalleitenden Stromzuführungen erheblich verringert.

Während eine solche hochtemperatursupraleitende Stromzuführungseinrichtung zwar zum einen widerstandslos Strom leitet und zum anderen nur einen geringen Wärmeübergang zwischen kälterem und wärmerem Temperaturreservoir erlaubt, stellt sie jedoch einen weiteren Unsicherheitsfaktor bezüglich eines Zusammenbruchs der hochtemperatursupraleitenden Eigenschaften und eines Übergangs zur Normalleitung dar.

Alle hochtemperatursupraleitenden Materialien können ihre supraleitenden Eigenschaften durch
a) Überschreiten einer kritischen Temperatur (T_{c}),
b) Überschreiten eines kritischen Magnetfeldes (H_{c}) oder
c) Überschreiten eines kritischen Stroms (I_{c}),
oder durch zwei oder mehr der genannten Ereignisse gleichzeitig, verlieren.

In diesen Fällen wird das Material normalleitend und ein hoher Widerstand tritt auf. Im Falle eines solchen Übergangs in einem Teil eines hochtemperatursupraleitenden Bauteils oder im gesamten vom Strom durchflossenen Bauteil, kann die durch den hohen Widerstand entstehende Ohm'sche Wärme in kürzester Zeit zur Zerstörung des Bauteils führen. Die Wärme kann nicht schnell genug abgeführt werden, so daß das Bauteil innerhalb von Sekunden zu schmelzen beginnen kann.

Setzt man ein solches Bauteil beispielsweise als Stromzuführung zu hochtemperatursupraleitenden Magnetspulen ein, so kann der fließende Strom in einem solchen Fall, speziell bei Magnetanwendungen mit hoher Induktivität, aufgrund der abrupten Zerstörung der Stromzuführung nicht langsam genug heruntergeregelt werden. Dies führt, wie bereits oben im Rahmen der Magnetspulenanwendung beschrieben, in der Regel zur Zerstörung der gesamten Spule. Zusätzlich können dabei eventuell auftretende Spannungsüberschläge unter Umständen zur Beschädigung der gesamten Anlage führen und deren kostspielige Erneuerung nötig machen.

Um hochtemperatursupraleitende Stromzuführungen vor solchen Ereignissen zu schützen, mußten bisher beispielsweise zusätzliche externe Normalleiter parallelgeschaltet werden oder aufwendige, schnelle und empfindliche Schalter eingerichtet werden, die bei Registrierung eines Spannungsabfalls über den gesamten Hochtemperatursupraleiter eine sofortige Stromabschaltung bewirken. Solche Normalleiter oder Schaltungseinrichtungen müssen dabei das obere und das untere Ende des zu schützenden Teils verbinden. Sie verursachen zusätzlichen Montageaufwand, benötigen viel Platz und außerdem muß aufgrund der Abkühlung auf kryogene Temperaturen auf eine angepaßte thermische Ausdehnung, bezogen auf das hochtemperatursupraleitende Bauteil selbst, geachtet werden. Ein voll kontinuierlicher Schutz, bei dem der Strom überall über das gesamte hochtemperatursupraleitende Bauteil hinweg vom Hochtemperatursupraleiter in einen parallellaufenden Normalleiter übergehen kann, ist mit einem solchen Baukonzept nicht zu erreichen. Zudem führen schnelle, empfindliche Schalter, die die ersten Anzeichen einer Normalleitung innerhalb des Hochtemperatursupraleiterbauteils detektieren sollen, häufig zu Fehlauslösungen, die das gesamte System unnötigerweise abschalten.

Ein stabilisierter keramischer Hochtemperatursupraleiter sowie ein Verfahren zu seiner Herstellung, ist aus der DE-A 4 124 980 bekannt. Beschrieben wird ein keramischer Hochtemperatursupraleiter, bei dem eine Bruchstelle so sicher stabilisiert wird, daß eine rechtzeitige Stromabschaltung erfolgen kann. Hierzu werden ein oder mehrere metallische Edelmetalldrähte in die Hochtemperatursupraleiterbauteile eingebracht. Hierdurch wird allerdings lediglich ein Schutz vor kleinen, lokalen Rissen im Hochtemperatursupraleiter und nicht vor dem Verlust der Supraleitereigenschaft im Bauteil sichergestellt.

Es bestand daher ein Bedarf nach Hochtemperatursupraleiterbauteilen, welche die Nachteile der aus dem Stand der Technik bekannten Bauteile nicht aufweisen. Der Erfindung lag damit die Aufgabe zugrunde, ein hochtemperatursupraleitendes Bauteil zur Verfügung zu stellen, das beim Überschreiten einer kritischen Temperatur (T_{c}), oder beim Überschreiten eines kritischen Magnetfeldes (H_{c}) oder beim Überschreiten eines kritischen Stroms (I_{c}) oder beim gleichzeitigen Eintreten von zwei oder mehr der genannten Ereignisse, den im Hochtemperatursupraleiter fließenden Strom zumindest für eine kurze Zeitdauer, die ausreicht, um die Stromführung ausreichend langsam herunterzuregeln und so weiterzuleiten, daß es nicht zu einer Zerstörung des hochtemperatursupraleitenden Bauteils und des daran anschließenden Systems kommt.

Die erfindungsgemäße Aufgabe wird dadurch gelöst, daß das hochtemperatursupraleitende Bauteil in einem Sicherungsbereich oder in mehreren Sicherungsbereichen derart mit einem normalleitenden Sicherungsleiter in Kontakt gebracht wird, daß der in einem solchen Sicherungsbereich fließende Strom beim Übergang des Hochtemperatursupraleiters zur Normalleitung in diesem Sicherungsbereich vom Normalleiter während einer Dauer von mindestens 1 Sekunde zerstörungsfrei im wesentlichen vollständig aufgenommen und weitergeleitet werden kann.

Gegenstand der Erfindung ist demnach ein hochtemperatursupraleitendes Bauteil mit einer hochtemperatursupraleitenden Querschnittsfläche von mindestens 1 mm², das einen Stromführungsabschnitt aufweist, wobei der Stromführungsabschnitt mit einem Sicherungsleiter verbunden ist der derart ausgebildet und angeordnet ist und derart mit dem Stromführungsabschnitt in elektrisch leitendem Kontakt steht und diesen in einem Sicherungsbereich zumindest teilweise bedeckt und zumindest teilweise umschließt, daß der im Sicherungsbereich des Stromführungsabschnitts fließende Strom beim Übergang des Hochtemperatursupraleiters zur Normalleitung in diesem Sicherungsbereich vom Sicherungsleiter während einer Dauer von mindestens 1 Sekunde zerstörungsfrei im wesentlichen vollständig aufgenommen und weitergeleitet wird, wobei der Sicherheitsbereich mindestens 10% der Oberfläche des Stromführungsabschnittes ausmacht, wobei zumindest ein Teil des Stromführungsabschnittes in seinem Umfang vollständig von dem Sickerungsleiter umfaßt ist.

Unter einer "im wesentlichen vollständigen" Aufnahme und Weiterleitung des Stromes wird im Rahmen der vorliegenden Erfindung eine Aufnahme und Weiterleitung eines zumindest überwiegenden Anteils des im Hochtemperatursupraleiter unter supraleitenden Bedingungen fließenden Stroms verstanden. Da der Hochtemperatursupraleiter auch im normalleitenden Zustand noch eine (wenn auch geringe) Leitfähigkeit besitzt, geht der im Hochtemperatursupraleiter unter supraleitenden Bedingungen fließende Strom beim Übergang zur Normalleitung im erfindungsgemäßen Bauteil nicht vollständig, sondern nur "im wesentlichen vollständig" auf den Sicherungsleiter über. Es fließt, entsprechend den Regeln der Elektrotechnik, auch im normalleitenden Zustand noch einen geringer Teil des Stroms im Hochtemperatursupraleiter.

Als "hochtemperatursupraleitendes Bauteil" wird im Rahmen der Erfindung ein Bauteil verstanden, das bei etwa 30 K oder darüber, über seine gesamte Länge eine widerstandslose Stromleitung ermöglicht. Hochtemperatursupraleitende Bauteile gemäß der vorliegenden Erfindung weisen demnach einen Anteil an hochtemperatursupraleitendem Material auf, wobei als hochtemperatursupraleitendes Material ein keramisches Material eingesetzt wird.

Die erfindungsgemäßen Bauteile können also bei einer Temperatur eingesetzt werden, bei der definitionsgemäß "Hochtemperatursupraleitung" herrscht. Es ist jedoch ebenso möglich, die erfindungsgemäßen Bauteile bei darunterliegenden Temperaturen einzusetzen, d. h. bei Temperaturen von weniger als etwa 30 K, beispielsweise bei etwa 4 K bis etwa 25 K.

In einer bevorzugten Ausführungsform der Erfindung weist das hochtemperatursupraleitende Bauteil einen Anteil an hochtemperatursupraleitendem Material von mindestens etwa 30 Gew.-% auf, beispielsweise mindestens etwa 35 Gew.-%, 40 Gew.-% oder darüber, beispielsweise mindestens etwa 50 Gew.-%. Es ist ebenso möglich, daß das erfindungsgemäße Bauteil einen Anteil an hochtemperatursupraleitendem Material von mehr als etwa 60 oder 70 Gew.-% aufweist. Dieser Gewichtsanteil bezieht sich dabei auf die Massensumme aus hochtemperatursupraleitendem Material und dem Sicherungsleiter, wie er weiter unten noch beschrieben wird. Gegebenenfalls noch zusätzlich am Bauteil angebrachte weitere Hilfsmittel, beispielsweise mechanische Verstärkungsmittel, Kontaktmittel, Temperaturfühler oder Spannungssensoren entlang des Bauteils werden in diese Berechnung des Gewichtsverhältnisses nicht miteinbezogen. Das hochtemperatursupraleitende Bauteil weist in einer bevorzugten Ausführungsform einen Stromführungsabschnitt auf, der aus massiver hochtemperatursupraleitender Keramik besteht. Eine solche massive Keramik kann beispielsweise durch isostatisches Pressen oder durch Gußverfahren erhalten werden.

Als hochtemperatursupraleitendes Material eignen sich alle hochtemperatursupraleitenden Materialien, die bei 50 K oder darüber supraleitende Eigenschaften aufweisen, d.h., Strom ohne Widerstand leiten. Das im Rahmen der vorliegenden Erfindung vorgestellte hochtemperatursupraleitende Bauteil kann sowohl zur Leitung von Gleichstrom als auch zur Leitung von Wechselstrom eingesetzt werden. In einer bevorzugten Ausführungsform der Erfindung erfolgt der Einsatz dieses Bauteils daher zur Leitung von Gleichstrom, in einer weiteren bevorzugten Ausführungsform zur Leitung von Wechselstrom.

Im Rahmen der vorliegenden Erfindung besonders geeignete hochtemperatursupraleitende Materialien sind beispielsweise Verbindungen der Zusammensetzung A_{1±x}M_{2±x}Cu₃O_{y}, wobei A für Y oder eine Kombination aus zwei oder mehr der Elemente Y, La, Lu, Sc, Sm, Nd oder Yb steht. M steht hierin für Ba oder eine Kombination aus zwei oder mehr der Elemente Ba, Sr oder Ca und y steht für eine Zahl, bei der das genannte Material bei einer Temperatur von mehr als 30 K, insbesondere bei mindestens etwa 77 K, supraleitend wird. Bei den Verbindungen handelt es sich um einphasige perovskitartige kristalline Strukturen, die beispielsweise durch Vermischen der Metalloxide oder von Verbindungen, die beim Erhitzen in Metalloxide übergehen, in den geeigneten molaren Verhältnissen, dem Aufheizen der Mischung in der Gegenwart von Sauerstoff auf eine Temperatur zwischen etwa 800 und etwa 1100°C und langsamem Abkühlen der Mischung in Gegenwart von Sauerstoff während eines Zeitraumes von mindestens etwa einer Stunde. Im einzelnen sind als geeignete Materialien zu nennen (Y_{0,8}Lu_{0,2})_{1,0}Ba_{2,0}Cu₃O_{y},
(Y_{0,5}Lu_{0,5})_{1,0}Ba_{2,0}Cu₃O_{y}, (Y_{0,5}La_{0,5})_{1,0}Ba_{2,0}Cu₃O_{y}, (Y_{0,5}Sc_{0,5})_{1,0}Ba_{2,0}Cu₃O_{y},
(La_{0,5}Sc_{0,5})_{1,0}Ba_{2,0}Cu₃O_{y}, Y_{1,0}(Ba_{0,5}Ca_{0,5})_{2,0}Cu₃O_{y}, Y_{1,0}(Sr_{0,5}Ca_{0,5})_{2,0}Cu₃O_{y},
Y_{0,8}Ba_{2,0}Cu₃O_{y}, Y_{1,2}Ba_{2,0}Cu₃O_{y}, Y_{1,0}Ba_{1,8}Cu₃O_{y}, Y_{1,0}Ba_{1,5}Cu₃O_{y}, Y_{1,2}Ba_{1,8}Cu₃O_{y}.
Besonders geeignet ist eine Gruppe von Materialien, die unter der Bezeichnung YBCO-123 und YBCO-211 bekannt sind, wobei die Zahlenkombinationen 123 und 211 für die stöchiometrischen Verhältnisse der Elemente Y, Ba und Cu stehen.
Weitere geeignete keramische Materialien, die Hochtemperatursupraleitung bei einer Temperatur von 30 K oder darüber zeigen, sind beispielsweise Verbindungen der allgemeinen Formel (Bi₁₋ₓAₓ)-B_{y}-C_{z}-CuO, worin A für Sb oder As oder deren Gemisch, B und C jeweils unterschiedlich sind und für ein oder mehrere Elemente ausgewählt aus der Gruppe bestehend aus Be, Mg, Ca, Sr und Ba stehen, 0≤x<1,0<y≤5 und 0 < z ≤ 5 stehen. Der (nicht indizierte) Anteil an Sauerstoff beträgt dabei in der oben angegebenen allgemeinen Formel etwa 3 bis 5, je nach Herstellungsverfahren und gewünschten Eigenschaften.

Bei den genannten Oxidverbindungen ist es wesentlich, Wismut (Bi) und Kupfer (Cu) mit mindestens zwei oder mehr Elementen ausgewählt aus der Gruppe Be, Mg, Ca, Sr, Ba und Pb zu kombinieren. Gegebenenfalls kann Bi teilweise durch Sb oder As oder beides substituiert werden. Besonders bevorzugt ist eine Kombination aus Bi, Sr, Ca, Cu und O. Die genannten Verbindungen werden durch Vermischen von Oxiden, Carbiden oder Carbonaten oder Gemischen aus zwei oder mehr davon der genannten Elemente in den geeigneten Mischungsverhältnissen hergestellt. Nachfolgend wird bei einer Temperatur von etwa 700 bis 900°C für einen Zeitraum von etwa 2 bis etwa 20 Stunden calciniert, das calcinierte Gemisch vermahlen, in geeignete Form gebracht und bei Temperaturen von etwa 800 bis etwa 1100°C im halb oder ganz geschmolzenen Zustand gesintert. Verbindungen der genannten Art zeigen beispielsweise eine Übergangstemperatur zur Supraleitung von mehr als 105 K und sind außerordentlich stabil. Beispiele für Verbindungen der genannten Art finden sich beispielsweise in der EP-B 0 330 305, auf die hier ausdrücklich Bezug genommen wird.

Weitere zum Einsatz als hochtemperatursupraleitendes Material im Rahmen der vorliegenden Erfindung geeignete Verbindungen werden beispielsweise in der EP-A 0 327 044 beschrieben, auf die ebenfalls ausdrücklich Bezug genommen wird. Hierbei handelt es sich um hochtemperatursupraleitende Massen mit einem Gehalt an Bi, Sr, Ca, Cu und O, die eine Bruttozusammensetzung Biₐ(Sr,Ca)_{b}Cu₆Oₓ aufweisen, wobei a = 3 bis 24 und b = 3,23 bis 24 beträgt und das Atomverhältnis Sr/Ca etwa 1:9 bis 9:1 beträgt. Das Atomverhältnis Bi : (Ca + Sr) beträgt etwa 0,3 bis etwa 1,5. Die genannten Verbindungen werden üblicherweise als BSCCO bezeichnet, wobei der Buchstabe B für das Element Wismut, der Buchstabe S für Strontium, der erste Buchstabe C für Calcium, der zweite Buchstabe C für Kupfer und O für Sauerstoff steht. In Abhängigkeit von der Zusammensetzung der Verbindungen werden die oben beschriebenen hochtemperatursupraleitenden Materialien auch häufig durch ihre Elementzusammensetzung charakterisiert. So steht die Bezeichnung BSCCO-2212 für hochtemperatursupraleitende Materialien der Zusammensetzung Bi₂Sr₂CaCu₂Oₓ und die Bezeichnung BSCCO-2223 für Verbindungen der stöchiometrischen Zusammensetzung Bi₂Sr₂Ca₂Cu₃Oₓ. Die Verbindungen werden in der Literatur beispielsweise auch häufig durch die Zahl der Schichten bezeichnet, die an ihrem Aufbau beteiligt sind. So wird beispielsweise BSCCO-2212 häufig als "Zweischichter" und BSCCO-2223 als "Dreischichter" bezeichnet.

Die genannten hochtemperatursupraleitenden Materialien können gegebenenfalls noch SrSO₄ oder BaSO₄ als Zuschlagstoffe in einer Menge von bis zu 20 Gew.-% (beim Einsatz von BaSO₄ vorzugsweise nur bis zu etwa 10 Gew.-%) enthalten. Ebenfalls im Rahmen der vorliegenden Erfindung einsetzbar sind Verbindungen der BSCCO-Klasse, bei denen ein Teil des Wismuts durch Blei ersetzt worden ist. Solche Verbindungen werden üblicherweise auch als Pb-BSCCO bezeichnet. Beispielsweise geeignet zum Einsatz im Rahmen der vorliegenden Erfindung ist die bleihaltige Verbindung (BiPb)₂Sr₂Ca₂Cu₃O₁₀.

Weiterhin geeignet sind hochtemperatursupraleitende Materialien, wie sie beispielsweise in der EP-B 0 659 704 genannt sind und auf die ausdrücklich Bezug genommen wird, die neben den Elementen Barium, Calcium, Kupfer und Sauerstoff noch mindestens Quecksilber enthalten. Zusätzlich kann noch ein weiteres Element oder ein Gemisch aus zwei oder mehr weiteren Elementen ausgewählt aus der Gruppe Pb, Bi, TI, Au, Pt, Ag oder Cd enthalten sein. Hochtemperatursupraleitende Oxide der Zusammensetzung (Hg, Pb), Ba, Ca, Cu in der stöchiometrischen Zusammensetzung 1223 werden beispielsweise von K. Isawa et al. in *Physica,* C 217 (1993), 11 - 15 beschrieben. Auf beide genannte Druckschriften wird hiermit ausdrücklich Bezug genommen.

Weitere geeignete hochtemperatursupraleitende Materialien sind in der WO 95/08517 beschrieben, auf die ebenfalls ausdrücklich Bezug genommen wird. Die Druckschrift beschreibt thalliumhaltige oxidkeramische Hochtemperatursupraleiter, mit denen beispielsweise massive Keramikbauteile erhalten werden können. Die genannten hochtemperatursupraleitenden Verbindungen weisen beispielsweise die Formelzusammensetzung Tl/PbCaₙ₋₁Ba₂CuₙOₓ, (Tl/Pb)₂Caₙ₋₁Ba₂CuₙO_{y} oder Tl_{0,5}Pb_{0,5}Caₙ₋₁Sr₂CuₙO_{z} auf. Hierin steht n beispielsweise für Zahlen von 1, 2 oder 3. Die Materialien weisen Übergangstemperaturen zur Hochtemperatursupraleitung (T_{c}) von deutlich mehr als 77 K auf, beispielsweise etwa 118 bis etwa 122 K. Entdeckung und Charakterisierung der Verbindungen wird beispielsweise von Z.Z. Cheng et al. in *Nature, Bd.* 332, *Seite 55 (1988)* beschrieben.

Ebenfalls geeignet sind beispielsweise Hochtemperatursupraleitermaterialien, wie sie in der EP-A 0 573 804 beschrieben werden. Solche Hochtemperatursupraleiter der BSCCO-Klasse weisen zur Erhöhung der kritischen Stromdichte im Gleichgewichtszustand einen Kohlenstoffgehalt von etwa 200 bis etwa 800 ppm (Gewichtseinheit) auf.

Das hochtemperatursupraleitende Bauteil gemäß der vorliegenden Erfindung ist in seiner Raumform nicht eingeschränkt, das erfindungsgemäße, weiter unter erläuterte Konzept des Sicherungsleiters läßt sich auf hochtemperatursupraleitende Bauteile nahezu aller möglichen Raumformen übertragen.
Im Rahmen der vorliegenden Erfindung bevorzugte Bauteile weisen jedoch eine langgestreckte Form auf, bei der die Länge des Bauteils ein Vielfaches des Bauteilquerschnitts beträgt. Unter einem Vielfachen werden im Rahmen der vorliegenden Erfindung nicht nur ganzzahlige Vielfache verstanden.

Das hochtemperatursupraleitende Bauteil kann dabei eine lineare Form aufweisen, es kann jedoch ebenso mäanderförmig gebogen oder spiralförmig gewunden sein, wenn eine geeignete Herstellungsweise dies zuläßt.

In einer bevorzugten Ausführungsform ist das erfindungsgemäße hochtemperatursupraleitende Bauteil jedoch im wesentlichen linear und weist eine Länge von mindestens etwa 1 cm auf. Die Länge des hochtemperatursupraleitenden Bauteils ist im wesentlichen nicht begrenzt und wird üblicherweise von der Art der Anwendung vorgegeben. So werden im Rahmen des Einsatzes der erfindungsgemäßen hochtemperatursupraleitenden Bauteile als Stromzuführungen zu hochtemperatursupraleitenden Magneten in der Regel Bauteillängen von etwa 5 bis etwa 100 cm, beispielsweise etwa 10 bis etwa 50 cm, gefordert.

Die Querschnittsfläche des hochtemperatursupraleitenden Bauteils kann eine beliebige äußere Form aufweisen, die lediglich von der Art der Herstellung abhängt. Möglich sind beispielsweise kreisförmige, ovale oder polygonale, insbesondere dreieckige, viereckige, beispielsweise quadratische oder rechteckige, fünfeckige oder sechseckige Querschnittsflächen.

Das hochtemperatursupraleitende Bauteil kann dabei massiv sein, d. h. ein Querschnitt durch das Bauteil ist vollständig mit hochtemperatursupraleitendem Material ausgefüllt. Das hochtemperatursupraleitende Bauteil kann jedoch auch hohl sein, d. h. ein Querschnitt durch das Bauteil weist eine von hochtemperatursupraleitendem Material umschlossene freie Fläche auf. Im Rahmen der vorliegenden Erfindung können sowohl massive als auch hohle hochtemperatursupraleitende Bauteile eingesetzt werden, die in einer bevorzugten Ausführungsform als Röhre oder als Stab ausgebildet sind.

Die Querschnittsfläche des hochtemperatursupraleitenden Materials beträgt in einer bevorzugten Ausführungsform mindestens etwa 2 mm², insbesondere mehr als etwa 5 mm². Beispielsweise sind im Rahmen der vorliegenden Erfindung Bauteile geeignet, die eine Querschnittsfläche von etwa 25 mm², etwa 50 mm², etwa 500 mm², etwa 1300 mm² oder etwa 2000 mm² aufweisen.

Das erfindungsgemäße hochtemperatursupraleitende Bauteil weist mindestens einen Stromführungsabschnitt auf. Als Stromführungsabschnitt wird derjenige Abschnitt des hochtemperatursupraleitenden Bauteils bezeichnet, welcher der Stromführung dient und keine weitere Kontaktfunktion hat außer gegebenenfalls Kontakten zu Meßgeräten, die beispielsweise Stromfluß oder Temperatur im Stromführungsabschnitt kontrollieren. Der Stromführungsabschnitt des erfindungsgemäßen hochtemperatursupraleitenden Bauteils steht mindestens teilweise, d. h., in dem Sicherungsbereich oder den Sicherungsbereichen, mit einem, vorzugsweise normalleitenden, Sicherungsleiter in Kontakt. Unter einem "teilweisen" Kontakt mit dem Sicherungsleiter wird im Rahmen des vorliegenden Textes verstanden, daß der Stromführungsabschnitt nicht auf seiner gesamten Länge mit dem Sicherungsleiter in Kontakt stehen muß, sondern daß bestimmte Längenanteile des Stromführungsabschnitts keinen Kontakt mit dem Sicherungsleiter aufweisen.

Als "Sicherungsbereich" wird im Rahmen des vorliegenden Textes der Bereich oder diejenigen Bereiche des Stromführungsabschnitts bezeichnet, in dem die Stromführung bei einem Übergang des hochtemperatursupraleitenden Materials zur Normalleitung vom Sicherungsleiter zumindest kurzzeitig, d. h. für eine Dauer von mindestens einer Sekunde, übernommen werden kann.

Die hochtemperatursupraleitenden Bauteile gemäß der vorliegenden Erfindung weisen in einer bevorzugten Ausführungsform Endabschnitte auf, die als Kontakte ausgebildet sind. Als "Endabschnitte" werden diejenigen Abschnitte des erfindungsgemäßen hochtemperatursupraleitenden Bauteils bezeichnet, die sowohl in mechanischem als auch in elektrisch leitendem Kontakt mit einer Stromquelle bzw. einem Verbraucher stehen. Als Stromquelle wird in diesem Zusammenhang jede Form der Stromzuführung verstanden, die dem hochtemperatursupraleitenden Bauteil Strom zuführt und damit in elektrisch leitender Verbindung steht, jedoch ansonsten nur kraft- oder formschlüssig oder beides verbunden ist. Als Stromabnehmer wird ein Bauteil verstanden, das mit Hilfe des durch das hochtemperatursupraleitende Bauteil zugeführten Stroms eine bestimmte Wirkung erzielt, beispielsweise ein Magnetfeld aufbaut.

Die Endabschnitte einer bevorzugten Ausführungsform des hochtemperatursupraleitenden Bauteils sind als Kontakte ausgebildet, d. h. sie weisen ein Kontaktmittel auf, das eine elektrisch leitende Verbindung des hochtemperatursupraleitenden Bauteils mit anderen Stromquellen oder -verbrauchern ermöglicht. Eine solche elektrisch leitende Verbindung kann beispielsweise dadurch hergestellt werden, daß das hochtemperatursupraleitende Bauteil im Umfang der Endabschnitte mit einem elektrisch leitenden Metall, vorzugsweise im gesamten Umfang des Endabschnitts, umgeben ist. Das elektrisch leitende Metall steht dabei derart mit dem hochtemperatursupraleitenden Material im Bereich des Endabschnitts so in Kontakt, daß ein möglichst geringer Durchgangswiderstand bei Übergang von Strom von einer Stromzuführung oder zu einem Stromabnehmer durch das Metall auf das hochtemperatursupraleitende Material, oder umgekehrt, gegeben ist.

Vorzugsweise beträgt dieser Widerstand weniger als 2 µΩ · cm (77 K), beispielsweise weniger als etwa 1,5 µΩ · cm, 1 µΩ · cm oder 0,5 µΩ · cm.

In einer weiteren bevorzugten Ausführungsform weist das hochtemperatursupraleitende Bauteil zwei Endabschnitte auf, deren Länge zusammengenommen weniger als etwa 40 % der Gesamtlänge des hochtemperatursupraleitenden Bauteils beträgt.

Der Kontakt zwischen dem hochtemperatursupraleitenden Bauteil und einer Stromzuführung oder einem Stromabnehmer wird beispielsweise durch geeignet ausgebildete Kupferkontakte hergestellt, die das hochtemperatursupraleitende Bauteil im wesentlichen über den gesamten Umfang und im wesentlichen über die gesamte Länge der Endabschnitte umfaßt.

In einer bevorzugten Ausführungsform der Erfindung steht das hochtemperatursupraleitende Bauteil an wenigstens einem Teil des Stromführungsabschnitts im Sicherungsbereich in vollem Umfang mit dem Sicherungsleiter in Kontakt. Vorzugsweise befindet sich ein solcher Teil des Stromführungsabschnitts in der Nähe eines der Endabschnitte oder grenzt insbesondere an einen der Endabschnitte an. In einer weiteren bevorzugten Ausführungsform steht das hochtemperatursupraleitende Bauteil mit der gesamten Oberfläche des Stromführungsabschnitts über dessen gesamte Länge mit dem Sicherungsleiter in Kontakt.

In einer weiteren bevorzugten Ausführungsform macht der Sicherungsbereich mindestens 10 % der Oberfläche des hochtemperatursupraleitenden Bauteils aus. Vorzugsweise ist der Kontakt zwischen Sicherungsleiter und Bauteil zusammenhängend und undurchbrochen vollflächig. Wird das hochtemperatursupraleitende Bauteil in einen Temperaturgradienten eingesetzt, so ist es im Rahmen der vorliegenden Erfindung bevorzugt, wenn der Sicherungsleiter wenigstens 30 % der an einen Endabschnitt oder an jeweilige Endabschnitte angrenzenden Oberfläche bedeckt, die mit dem wärmeren Temperaturniveau in Kontakt stehen. D. h. in einer bevorzugten Ausführungsform der Erfindung befindet sich mindestens ein Sicherungsbereich an einem solchen Endabschnitt des Bauteils.

Der Kontakt zwischen Sicherungsleiter und hochtemperatursupraleitendem Material kann innerhalb des Stromführungsabschnitts abrupt abbrechen, es kann jedoch eine Übergangszone eingerichtet werden, in welcher der Kontakt zwischen hochtemperatursupraleitendem Material und Sicherungsleiter graduierlich abnimmt bzw. die Stromtragfähigkeit des Sicherungsleiters graduierlich verringert wird. Eine solche Verringerung der Stromtragfähigkeit kann beispielsweise dadurch geschehen, daß die Dicke des Sicherungsleiters von der ursprünglichen Dicke bis auf eine wesentlich geringere Dicke graduierlich auslaufend verringert wird. Der Kontakt zwischen hochtemperatursupraleitendem Material und Sicherungsleiter kann auch dadurch graduierlich verringert werden, daß im Sicherungsleiter Aussparungen vorgenommen werden, deren Flächenausdehnung mit zunehmender Entfernung von der vollflächigen Bedeckung des hochtemperatursupraleitenden Materials mit dem Sicherungsleiter zunehmen. Solche Aussparungen können beispielsweise dreieckig oder rautenförmig sein, und können sich über relativ kurze Längenabschnitte oder über Längenabschnitte erstrecken, welche die gesamte, nicht vollflächig vom Sicherungsleiter bedeckte Länge des Stromführungsabschnitts betreffen.

Der Sicherungsleiter kann daher sowohl mit allen als Kontakt ausgebildeten Endabschnitten in elektrisch leitendem Kontakt stehen, es kann jedoch auch lediglich zu einem Endabschnitt elektrisch leitender Kontakte zwischen Sicherungsleiter und als Kontakt ausgebildetem Endabschnitt bestehen.

Der Sicherungsleiter sollte in einer bevorzugten Ausführungsform der Erfindung immer mit mindestens einem als Kontakt ausgebildeten Endabschnitt in elektrisch leitender Verbindung stehen. Eine solche Verbindung kann beispielsweise dadurch erreicht werden, daß zwischen als Kontakt ausgebildetem Endabschnitt und Sicherungsleiter durch geeignete Hilfsmittel, beispielsweise Lot, eine elektrisch gut leitende Verbindung hergestellt wird. Es ist jedoch ebenso möglich, den Kontakt aus dem gleichen Material herzustellen, aus dem der Sicherungsleiter besteht, und über den Endabschnitt hinausgehend den Kontakt als Sicherungsleiter in den Stromführungsabschnitt übergehend auszubilden.

Ist das erfindungsgemäße hochtemperatursupraleitende Bauteil hohl, d. h. weist es einen vollflächig von hochtemperatursupraleitendem Material umschlossenen Hohlraum auf, so muß der Sicherungsleiter nicht notwendigerweise mit der nach außen gerichteten Oberfläche des hochtemperatursupraleitenden Bauteils in Kontakt stehen, sondern kann genausogut auf der nach innen gerichteten Oberfläche des Bauteils aufgetragen sein.

Weiterhin ist es möglich, und im Rahmen der vorliegenden Erfindung als bevorzugte Ausführungsform vorgesehen, daß der Sicherungsleiter nicht auf einer der Oberflächen des hochtemperatursupraleitenden Bauteils aufliegt, sondern ganz oder teilweise vom hochtemperatursupraleitenden Material umgeben ist. Ausschlaggebend ist in diesem Zusammenhang, daß das der Erfindung zugrundeliegende Konzept durchgeführt werden kann, d. h. daß ein Übertritt des wenigstens in einen Teil des Hochtemperatursupraleiters fließenden Stroms in den Sicherungsleiter und gegebenenfalls aus dem Sicherungsleiter zurück in das hochtemperatursupraleitende Bauteil möglich ist.

Als Material für den Sicherungsleiter sind alle Materialien geeignet, die dazu in der Lage sind, den im hochtemperatursupraleitenden Bauteil in den mit dem Sicherungsleiter in Kontakt stehenden Abschnitten fließenden kritischen Strom bei einem Übergang dieses Abschnitts des hochtemperatursupraleitenden Bauteils in den normalleitenden Zustand aufzunehmen und über einen Zeitraum von mindestens einer Sekunde weiterzuleiten, ohne daß es zu einer Zerstörung des hochtemperatursupraleitenden Bauteils oder des Sicherungsleiters kommt. In einer bevorzugten Ausführungsform der Erfindung wird der Sicherungsleiter so gestaltet und dimensioniert, daß eine Weiterleitung des Stroms für eine Zeitdauer von mindestens 10 Sekunden oder darüber gegeben ist. Geeignete und ausreichende Zeiten, während deren der Strom störungsfrei weitergeleitet werden kann, können beispielsweise etwa 60 Sekunden oder mehr betragen, beispielsweise etwa 120 Sekunden oder sogar darüber.

Ein solches Material kann beispielsweise ein entsprechender leitfähiger Kunststoff sein, vorzugsweise wird jedoch im Rahmen der vorliegenden Erfindung als Material für den Sicherungsleiter ein Metall eingesetzt. Besonders geeignet sind die Edelmetalle, insbesondere Ag, Au, Pt, Rh, Pd, Ru, Os oder Ir oder Gemische aus zwei oder mehr davon.

In einer bevorzugten Ausführungsform wird als Material für den Sicherungsleiter ein Material eingesetzt, das sauerstoffpermeabel ist.

Vorzugsweise wird als Material für den Sicherungsleiter Ag, oder eine Legierung aus Ag mit Au eingesetzt, wobei der Anteil an Au beispielsweise etwa 0,1 bis etwa 20 Gew.-% beträgt.

In einer bevorzugten Ausführungsform der Erfindung wird als Sicherungsleiter ein Silberblech oder ein Blech aus einer Legierung von Silber und Gold eingesetzt. Der Sicherungsleiter steht dabei beispielsweise schichtartig mit der Oberfläche des hochtemperatursupraleitenden Materials in Kontakt. Der Sicherungsleiter weist in einer bevorzugten Ausführungsform der Erfindung eine Dicke von etwa 20 µm bis etwa 800 µm auf. Bei darunterliegenden Dicken ist gegebenenfalls eine zerstörungsfreie Aufnahme und Weiterleitung des im entsprechenden Abschnitt des Hochtemperatursupraleiters fließenden Stroms nicht mehr gewährleistet, bei darüber hinausgehenden Schichtdicken kann die Wärmeleitfähigkeit des hochtemperatursupraleitenden Bauteils eventuell unvorteilhaft hoch werden.

Gegebenenfalls kann es notwendig oder bevorzugt sein, wenn das hochtemperatursupraleitende Bauteil mit dem Sicherungsleiter von einer zusätzlichen Verstärkungsschicht umgeben ist. Die zusätzliche Verstärkungsschicht kann dabei das hochtemperatursupraleitende Bauteil vollflächig, jedoch mindestens unter Aussparung der als Kontakte ausgebildeten Endabschnitte, umhüllen, oder kann lediglich in Teilbereichen das hochtemperatursupraleitende Bauteil umhüllen oder mit ihm in Kontakt stehen. Die Verstärkungsschicht kann aus einem elektrisch leitenden oder aus einem elektrisch nichtleitenden Material bestehen. Vorzugsweise besteht die Verstärkungsschicht aus Metall und weist eine Dicke von etwa 40 µm bis etwa 10 mm auf. In einer bevorzugten Ausführungsform enthält die Verstärkungsschicht Kupfer, Eisen, Nickel oder Silber oder ein Gemisch aus zwei oder mehr davon.

Gegebenenfalls kann es vorteilhaft sein, wenn das hochtemperatursupraleitende Bauteil auf der Verstärkungsschicht umfänglich einen oder mehrere Abschnitte aufweist, die mit einem Metall in Verbindung stehen, dessen Wärmekapazität größer ist als die Wärmekapazität der Verstärkungsschicht. Solche Abschnitte werden in der Regel als Wärmesenken aufgebracht, die gegebenenfalls während einer normalleitenden Phase des hochtemperatursupraleitenden Bauteils entstehende Wärme speichern und bei einer darauffolgenden Abkühlphase wieder langsam abgeben.

Das erfindungsgemäße hochtemperatursupraleitende Bauteil wird in der Zeichnung näher erläutert. In der Zeichnung stellt

Fig. 1a ein röhrenförmiges, hochtemperatursupraleitendes Bauteil dar, bei dem eine Röhre aus hochtemperatursupraleitendem Material (1) zwei als Kontakte ausgebildete Endabschnitte (2) aufweist, und der dazwischenliegende Stromführungsabschnitt vollflächig von einem Sicherungsleiter (3) umgeben ist.

Fig. 1b zeigt ebenfalls ein röhrenförmiges, hochtemperatursupraleitendes Bauteil mit einer Röhre aus hochtemperatursupraleitendem Material (1), das Endabschnitte 2 und 2a aufweist, wobei Endabschnitt 2a dergestalt als Kontakt ausgebildet ist, daß der die Röhre aus hochtemperatursupraleitendem Material umhüllende Sicherungsleiter (3) nahtlos in den Endabschnitt 2a übergeht und dadurch einen Kontakt ausbildet. Etwa in der Mitte des Stromführungsabschnitts verringert sich der Kontakt zwischen Sicherungsleiter (3) und hochtemperatursupraleitendem Material (1), indem der Sicherungsleiter zackenförmige Aussparungen aufweist.

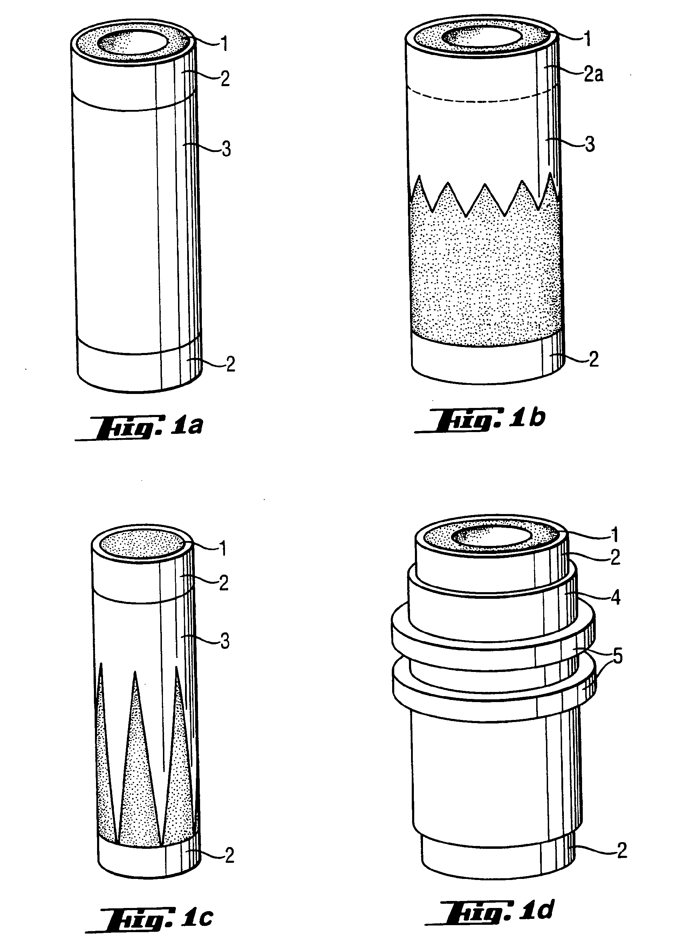

Fig. 1 c zeigt ein stabförmiges, massives hochtemperatursupraleitendes Bauteil, bei dem ein Stab aus hochtemperatursupraleitendem Material (1) zwei als Kontakte ausgebildete Endabschnitte (2) aufweist und der Stromführungsabschnitt von einem Sicherungsleiter (3) umgeben ist. Der Sicherungsleiter (3) weist ebenfalls dreieckige Aussparungen auf, die eine graduelle Abnahme des Kontakts zwischen Sicherungsleiter (3) und hochtemperatursupraleitendem Material (1) bewirken. Der Sicherungsleiter steht in diesem Fall in leitender Verbindung zu beiden als Kontakt ausgebildeten Endabschnitten (2).

Fig. 1d zeigt ein röhrenförmiges hochtemperäfursupraleitendes Bauteil mit einer Röhre aus hochtemperatursupraleitendem Material (1), als Kontakten ausgebildeten Endabschnitten (2), einem (hier nicht dargestellten) Sicherungsleiter, einer Verstärkungsschicht (4) und zwei ringförmig auf der Verstärkungsschicht aufliegenden Wärmesenken (5).

Das erfindungsgemäße hochtemperatursupraleitende Bauteil wird vorzugsweise mit hochtemperatursupraleitenden Materialien hergestellt, die sich im Rahmen von Guß- oder Schleuderverfahren verarbeiten lassen. Besonders bevorzugt ist im Rahmen der vorliegenden Erfindung die Verwendung von hochtemperatursupraleitenden Materialien des Typs BSCCO-2212 oder BSCCO-2223.

Der Sicherungsleiter kann dabei entweder vor, während oder nach der Ausbildung der hochtemperatursupraleitenden Eigenschaften des hochtemperatursupraleitenden Materials mit dem hochtemperatursupraleitenden Material in Kontakt gebracht werden.

In einer bevorzugten Ausführungsform wird das hochtemperatursupraleitende Bauteil dadurch mit dem Sicherungsleiter in Kontakt gebracht, daß die Innenwand einer geeigneten Gießform, die beispielsweise auch rotierend für Schleudergußverfahren eingesetzt werden kann, mit einem als Sicherungsleiter geeigneten Schicht, beispielsweise einem entsprechenden Blech, versehen wird und anschließend das hochtemperatursupraleitende Material (das noch nicht notwendigerweise in seiner endgültigen, die hochtemperatursupraleitenden Eigenschaften aufweisenden Form vorliegen muß), vergossen wird.

Gegenstand der Erfindung ist daher auch ein Verfahren zur Herstellung eines erfindungsgemäßen hochtemperatursupraleitenden Bauteils, bei dem die Innenseite einer Gußform mit einem Blech enthaltend Ag, Au, Pt, Rh, Pd, Ru, Os oder Ir oder ein Gemisch aus zwei oder mehr davon, ausgekleidet und die Gußform anschließend mit einer Schmelze eines Materials beaufschlagt wird, das gegebenenfalls nach entsprechender Nachbehandlung hochtemperatursupraleitende Eigenschaften aufweist.

Es ist dabei unerheblich, ob ein Gießverfahren mit statischer oder bewegter Gußform, beispielsweise Schleuderguß, angewandt wird.

Eine weitere Möglichkeit zum äußerlichen Auftragen des Sicherungsleiters besteht dann daß hochtemperatursupraleitendes Material durch entsprechende Bedampfungsverfahren, beispielsweise Plasmaverfahren oder Sputtern, auf das Bauteil aufgetragen wird.

Zum Herstellen der hochtemperatursupraleitenden Eigenschaften kann es beispielsweise notwendig sein, das gesamte Bauteil, d. h. hochtemperatursupraleitendes Material und Sicherungsleiter in entsprechender Form, beispielsweise durch Tempern, nachzubehandeln, um die hochtemperatursupraleitenden Eigenschaften zu modifizieren. Häufig wird ein solches Tempern in sauerstoffhaltiger Atmosphäre durchgeführt.

Die Verstärkungsschicht kann nach Fertigstellung des hochtemperatursupraleitenden Materials auf beliebige Weise auf dem hochtemperatursupraleitenden Bauteil aufgebracht werden. Wenn der Sicherungsleiter die Oberfläche des hochtemperatursupraleitenden Bauteils bildet, so ist es vorteilhaft, wenn die Verstärkungsschicht beispielsweise durch Löten oder sonstige metallische Verbindung auf dem Sicherungsleiter bzw. auf der Oberfläche des hochtemperatursupraleitenden Materials aufgebracht wird. Gegebenenfalls kann dies beispielsweise auch durch Bohrungen und entsprechende Verschraubung oder sonstige Befestigungsvorrichtungen erfolgen.

Ein weiterer Gegenstand der Erfindung ist die Verwendung eines erfindungsgemäßen hochtemperatursupraleitenden Bauteils oder eines nach einem erfindungsgemäßen Verfahren hergestellten hochtemperatursupraleitenden Bauteils als Stromzuführung.

Die Erfindung wird nachfolgend durch Beispiele näher erläutert.

### Beispiele:

Die nachfolgend genannten Ströme beziehen sich auf einen Stromfluß, bei dem am hochtemperatursupraleitenden Bauteil ein Spannungsabfall von 1 µV/cm gemessen wird.

### Beispiel 1 :

Aus einem 0,2 mm dicken Blech einer Legierung aus 97 Gew.-% Ag und 3 Gew.-% Au wurde ein Rohr von 8 mm Außendurchmesser und 100 mm Länge geformt. Diese Konstruktion wurde in ein einseitig verschlossenes Quarzglasrohr von 8 mm lichtem Durchmesser und 120 mm Länge als Kokille hineingeschoben. Eine Mischung der Oxide von Wismut, Strontium, Calcium und Kupfer im Verhältnis der Metalle von 2:2:1:2 wurde auf 1000°C aufgeheizt, bis eine homogene Schmelze entstand. Anschließend wurde diese Schmelze in das vorbereitete Quarzrohr gegossen. Nach der Abkühlung auf Raumtemperatur wurde die nun von dem anfänglich in die Kokille eingefügten Blech ummantelte, erstarrte Schmelze dem Quarzrohr entnommen. Der so erhaltene ummantelte Stab wurde in einem Ofen in einem Gemisch aus Luft und Sauerstoff (1:1) auf 750°C aufgeheizt, dort für 24 Stunden gehalten und anschließend bei 830°C unter Luft weitergeglüht. Das so erhaltene Bauteil wurde bei 90 K hochtemperatursupraleitend und trug bei 77 K (in flüssigem Stickstoff, IN₂) einen supraleitenden Strom (1 µV/cm) von 480 A. Zog man die Probe bei 450 A aus dem Stickstoffbad, daß nur noch ein Kontakt im Bad verblieb, konnte das Bauteil den Strom noch über mehrere Minuten leiten, ohne daß es zur Schädigung kam. Der nicht mehr im Stickstoffbad befindliche Kontakt wies dabei eine Temperatur von 120 K auf.

### Beispiel 2 :

Aus einem 0,25 mm dicken Silberblech wurde ein Rohr von 70 mm Durchmesser und 100 mm Länge geformt. Ein Ende dieses Rohres war dabei nicht glatt, sondern in Form einer Zackenkrone ausgebildet (siehe Fig. 1b). Ein weiteres Silberrohr von 20 mm Länge und 70 mm Durchmesser wurde zusätzlich geformt. Beide Rohre wurden an den Enden in einer rohrförmigen 200 mm langen Stahlmatrize (Kokille) eingelegt, so daß ein 80 mm langer silberfreier Bereich in der Mitte verblieb. Eine Mischung der Oxide von Wismut, Strontium, Calcium und Kupfer im Verhältnis der Metalle von 2:2:1:2 plus 10 Gew.-% SrSO₄ wurde auf 1100°C aufgeheizt, bis eine homogene Schmelze entstand. Die Kokille wurde in Rotation versetzt, und es wurde so viel Schmelze in die Kokille vergossen, daß sich nach Abkühlung eine 5 mm dicke Schicht aus erstarrter Schmelze ergab. Nach Abkühlung auf Raumtemperatur wurde das nun teilweise von Silber ummantelte Formteil der Kokille entnommen. Anschließend wurde es entsprechend den Bedingungen in Beispiel 1 nachgetempert und die erstarrte Schmelze zur hochtemperatursupraleitenden Phase umgesetzt. Das so erhaltene, röhrenförmige Bauteil zeigte bei 77 K einen kritischen Strom von 6486 A (1 µV/cm). Anschließend wurde ein Strom von konstant 6000 A angelegt und die Probe langsam aus dem flüssigen Stickstoffbad herausgezogen. Durch das Aufwärmen verlor das Rohr seine hochtemperatursupraleitende Eigenschaft, dennoch wurde der Strom bis zum Erreichen einer Spannung von 18 mV längs der Gesamtlänge des Rohres (nach etwa 500 s) aufrechterhalten und erst danach binnen weiterer 120 Sekunden langsam auf 0 geregelt. Das Rohr befand sich dabei nur noch mit der unteren Hälfte (der silberfreien Hälfte) im flüssigen Stickstoffbad. Der aus dem Stickstoffbad herausragende Bereich des Rohres wies dabei eine Temperatur von bis zu 110 K auf, was deutlich oberhalb der Sprungtemperatur liegt. Das Rohr trug damit im normalleitenden Zustand einen Strom von 6000 A. Nach erfolgtem Wiederabkühlen auf 77 K zeigte die Probe den gleichen kritischen Strom wie vor dem Test.

### Beispiel 3 :

An ein 0,3 mm dickes und 160 mm breites Blech aus 95 Gew.-% Ag und 5 Gew.-% Au wurden rechts und links zwei 0,2 mm dicke Silberbleche (100 % Ag) von 30 mm bzw. 60 mm Breite angeschweißt. Aus diesem Verbund wurde anschließend ein Rohr von 70 mm Durchmesser und 250 mm Länge geformt. Dieses Rohr wurde in eine entsprechende Stahlmatrize (Kokille) geschoben und in Rotation versetzt. Wie in Beispiel 2 beschrieben, wurde eine Metalloxidschmelze in die Kokille gegossen, bis sich eine 7 mm dicke Wandung ergab. Das so erhaltene Rohr wurde wie unter Beispiel 2 beschrieben nachgetempert und zeigte Hochtemperatursupraleitung unterhalb 90 K. Bei 77 K wies es einen kritischen Strom von 6006 A auf. Auf dieses hochtemperatursupraleitende Rohr mit AgAu-Hülle wurde nun eine Stahlhülle der Dicke 2 mm, bestehend aus vier einzelnen Rohrsegmenten, aufgelötet, so daß am oberen und am unteren Ende des Rohres noch jeweils ein 20 mm langes Stück aus Ag-beschichtetem Rohr freiblieben. Zusätzlich wurden noch 28 mm breite Kupferringe als Wärmesenken aufgelötet.

Bei einer Temperatur von 77 K wurde das Rohr mit einem Strom von 5500 A beaufschlagt. Anschließend wurde die Probe schnell bis auf einen Kontakt aus dem Flüssigstickstoffbad herausgezogen. Durch das anschließende Aufwärmen verlor das Rohr seine hochtemperatursupraleitende Eigenschaft, dennoch wurde der Strom bis zum Erreichen einer Spannung von 40 mV längs des Rohres für ca. 105 Sekunden nach dem Entfernen der Kühlung aufrechterhalten und erst danach während etwa weiterer 60 Sekunden langsam auf 0 geregelt. Das Rohr hat damit ohne Kühlung in normalleitendem Zustand den Strom von 5500 A getragen. Nach dem Wiederabkühlen auf 77 K zeigte die Probe denselben hochtemperatursupraleitenden kritischen Strom wie vor dem Test.

### Beispiel 4 :

Aus einer homogenen Pulvermischung von 100 Gewichtsteilen YBCO-123, mit 9 Teilen Y₂O₃ und einem Teil PtO₂ wurde mittels kaltisostatischem Pressen ein Stab von 12 mm Durchmesser und 120 mm Länge hergestellt. Dieses Teil wurde anschließend bei 880 bis 920°C gesintert und bei 1040°C partiell aufgeschmolzen. Nach dem Abkühlen auf 970°C erfolgte das Auskristallisieren der 123-Phase durch weiteres langsames Abkühlen. Auf diese Weise wurde ein Stab von 10 mm Durchmesser und 110 mm Länge erhalten. Anschließend wurde mittels thermischem Spritzen eine 0,18 mm dicke Schicht aus Silber über eine Länge von 45 mm an einem Ende des Stabs und über 10 mm Länge am anderen Ende des Stabs aufgetragen. Anschließend wurde das Bauteil einer Temperatur bei in Sauerstoff zwischen 400 und 600°C für 100 Stunden unterzogen. Auf diese Weise erhielt man ein hochtemperatursupraleitendes Bauteil mit einer Sprungtemperatur von 92 K und als Kontakten ausgebildeten Endabschnitten an beiden Enden. Das Bauteil zeigte die bereits beschriebene Schutzwirkung beim Verlust der hochtemperatursupraleitenden Eigenschaften.

### Beispiel 5 :

Gemäß Beispiel 4 wurde ein Stab hergestellt, allerdings aus einem Precursorpulver der Zusammensetzung Bi_{1,73}, Pb_{0,4}, Ca_{1,9}, Sr_{2,0}, Cu_{3,0} und Oₓ. Dieser wurde anschließend einer Reaktionsglühung bei 825°C (120h in N₂ + 1 % O₂) unterzogen. Auf diese Weise wurde ein Hochtemperatursupraleiterstab mit einer Sprungtemperatur von 110 K hergestellt. Anschließend wurde, wie in Beispiel 4 dargestellt, eine Silberschicht an beiden Enden aufgebracht. Auch dieses hochtemperatursupraleitende Bauteil zeigt die bereits beschriebenen Schutzwirkungen beim Verlust der hochtemperatursupraleitenden Eigenschaften.

### Vergleichsbeispiel :

Gemäß Beispiel 2 wurde ein hochtemperatursupraleitendes Bauteil hergestellt, bei dem jedoch im Stromführungsabschnitt kein Sicherungsleiter aufgebracht wurde. Die Kokille wurde lediglich an beiden Enden mit jeweils einem Silberrohr von 70 mm Durchmesser und 20 mm Länge belegt, durch welche die Endabschnitte als Kontakte ausgebildet wurden. Mittels Schleuderguß wurde dann gemäß Beispiel 2 ein Rohr hergestellt und nachgetempert. Das erhaltene Bauteil zeigte bei 77 K einen kritischen Strom von 6656A. Anschließend wurde das Bauteil bei einem Stromfluß von 6000 A gemäß Beispel 2 aus dem Stickstoffbad entnommen. Nach Bereits nach 45 s trat ein Spannungsabfall im Bereich der oberen 32 mm des Rohres (d. h. an dem aus dem Stickstoffbad herausragenden Ende) auf, der binnen weiterer 5 s zur vollständigen Zerstörung des Bauteils führte. Ein etwa 5 cm² großes Stück brach aus dem Bauteil heraus. Außerhalb des schließlich zerstörten Bereichs wurde während der gesamten Zeit lediglich ein Spannungsabfall von 8 µV beobachtet. Die gesamte Energie wurde demnach innerhalb des anschließend zerstörten Segments freigesetzt.

## Patentansprüche

1. Hochtemperatursupraleitendes Bauteil mit einer hochtemperatursupraleitenden Querschnittsfläche von mindestens 1 mm², das einen Stromführungsabschnitt aufweist, wobei der Stromführungsabschnitt mit einem Sicherungsleiter verbunden ist der derart ausgebildet und angeordnet ist und derart mit dem Stromführungsabschnitt in elektrisch leitendem Kontakt steht und diesen in einem Sicherungsbereich zumindest teilweise bedeckt und zumindest teilweise umschließt, dass der im Sicherungsbereich des Stromführungsabschnitts fließende Strom beim Übergang des Hochtemperatursupraleiters zur Normalleitung in diesem Sicherungsbereich vom Sicherungsleiter während einer Dauer von mindestens 1 Sekunde zerstörungsfrei im Wesentlichen vollständig aufgenommen und weitergeleitet wird, wobei der Sicherungsbereich mindestens 10 % der Oberfläche des Stromführungsabschnittes ausmacht, wobei zumindest ein Teil des Stromführungsabschnittes in seinem Umfang vollständig von dem Sicherungsleiter umfasst ist.

2. Hochtemperatursupraleitendes Bauteil nach Anspruch 1 , **gekennzeichnet durch** eine runde, ovale oder polygonale, insbesondere dreieckige, viereckige, fünfeckige oder sechseckige Querschnittsfläche.

3. Hochtemperatursupraleitendes Bauteil nach Anspruch 1 oder 2, **dadurch gekennzeichnet daß** es als Röhre oder als Stab ausgebildet ist.

4. Hochtemperatursupraleitendes Bauteil nach einem der Ansprüche 1 bis 3, **dadurch gekennzeichnet, daß** der Stromführungsabschnitt mit dem Sicherungsleiter mit mindestens 10 % seiner Oberfläche zusammenhängend und undurchbrochen in vollflächigem leitenden Kontakt steht.

5. Hochtemperatursupraleitendes Bauteil nach einem der Ansprüche 1 bis 4, **dadurch gekennzeichnet, daß** der Sicherungsleiter ein Element ausgewählt aus der Gruppe bestehend aus Ag, Au, Pt, Rh, Pd, Ru, Os oder Ir oder zwei oder mehr davon enthält.

6. Hochtemperatursupraleitendes Bauteil nach einem der Ansprüche 1 bis 5, **dadurch gekennzeichnet, daß** der Sicherungsleiter eine Dicke von 20 µm bis 800 µm aufweist.

7. Hochtemperatursupraleitendes Bauteil nach einem der Ansprüche 1 bis 6, **dadurch gekennzeichnet, daß** als hochtemperatursupraleitendes Material ein keramisches Material enthaltend die Elemente Cu und O sowie Bi, Sr und Ca, oder Pb, Bi, Sr und Ca, oder Tl, Pb, Ba, Sr und Ca oder Hg, Ba und Ca oder Hg, Pb, Ba und Ca oder RE und Ba eingesetzt wird, wobei RE für die Elemente Y, Nd, Sm, Eu, La, Gd Dy, Ho, Er oder Yb oder ein Gemisch aus zwei oder mehr davon steht.

8. Hochtemperatursupraleitendes Bauteil nach einem der Ansprüche 1 bis 7, **dadurch gekennzeichnet, daß** es eine mindestens abschnrttsweise mit der Oberfläche des Stromführungsabschnitts oder mit der Oberfläche des Sicherheitsleiters oder mit beiden Oberflächen in Kontakt stehende Verstärkungsschicht aufweist.

9. Hochtemperatursupraleitendes Bauteil nach Anspruch 8, **dadurch gekennzeichnet, daß** die Verstärkungsschicht eine Metallschicht mit einer Dicke von 40 µm bis 10 mm ist

10. Hochtemperatursupraleitendes Bauteil nach Anspruch 8 oder 9, **dadurch gekennzeichnet, daß** die Verstärkungsschicht Cu, Fe, Ni oder Ag enthält.

11. Hochtemperatursupraleitendes Bauteil nach einem der Ansprache 8 bis 10, **dadurch gekennzeichnet, daß** auf der Verstärkungsschicht umfänglich ein oder mehrere Abschnitte mit einem Metall in Verbindung stehen, dessen Wärmekapazität größer ist als die der Verstärkungsschicht.

12. Verfahren zur Herstellung eines hochtemperatursupraleitenden Bauteils gemäß einem der Ansprüche 1 bis 11, bei dem die Innenseite einer Gußform mit einem Blech enthaltend Ag, Au, Pt, Rh, Pd, Ru, Os oder Ir oder ein Gemisch aus zwei oder mehr davon, ausgekleidet und die Gußform anschließend mit einer Schmelze eines Materials beaufschlagt wird, das gegebenenfalls nach entsprechender Nachbehandlung hochtemperatursupraleitende Eigenschaften aufweist.

13. Verwendung eines hochtemperatursupraleitenden Bauteils gemäß einem der Ansprüche 1 bis 11 oder hergestellt nach Anspruch 12 als Stromzuführung.

## Claims

1. A high-temperature superconductor component with a high-temperature superconductor cross-sectional area of at least 1 mm², which has a current-carrying section, wherein the current-carrying section is connected to a safety conductor, which is designed and arranged in such a way, and is in electrical contact with the current-carrying section, and at least partially covers the latter in a safety region, or at least partially encloses the latter, in such a way that the current flowing in the safety region of the current-carrying section on transition of the high-temperature superconductor to normal conduction in this safety region is essentially fully taken up for a period of at least 1 second without damage, and rerouted by the safety conductor, wherein the safety region makes up at least 10% of the surface of the current-carrying section, wherein at least part of the current-carrying section is encompassed completely in its periphery.

2. The high-temperature superconductor component according to claim 1, **characterized by** a round, oval, or polygonal, particularly a triangular, quadrilateral, pentagonal, or hexagonal cross-sectional area.

3. The high-temperature superconductor component according to claim 1, **characterized in that** it is embodied as a tube or as a rod.

4. The high-temperature superconductor component according to one of the claims 1 to 3, **characterized in that** the current-carrying section is continuously and uninterruptedly in full conducting contact with the safety conductor via at least 10% of its surface area.

5. The high-temperature superconductor component according to one of the claims 1 to 4, **characterized in that** the safety conductor contains an element selected from the group consisting of Ag, Au, Pt, Rh, Pd, Ru, Os, or IR, or two or more thereof.

6. The high-temperature superconductor component according to one of the claims 1 to 5, **characterized in that** the safety conductor has a thickness of 20 µm to 800 µm.

7. The high-temperature superconductor component according to one of the claims 1 to 6, **characterized in that** a ceramic material containing the elements Cu and O, as well as Bi, Sr, and Ca, or Pb, Bi Sr, and Ca, or Tl, Pb, Ba Sr, and Ca, or Hg, Ba, and Ca, or Hg, Pb, Ba, and Ca, or RE and Ba is used as the high-temperature superconducting material, wherein RE stands for the elements Y, Nd, Sm, Eu, La, Gd, Dy, Ho, Er or Yb, or a mixture of two or more thereof.

8. The high-temperature superconductor component according to one of the claims 1 to 7, **characterized in that** it has a reinforcing layer being in contact with at least a section of the surface of the current-carrying section, or with the surface of the safety conductor, or with both surfaces.

9. The high-temperature superconductor component according to claim 8, **characterized in that** the reinforcing layer is a metal layer having a thickness of 40 µm to 10 mm.

10. The high-temperature superconductor component according to claims 8 or 9, **characterized in that** the reinforcing layer contains Cu, Fe, Ni, or Ag.

11. The high-temperature superconductor component according to one of the claims 8 to 10, **characterized in that** on the reinforcing layer, one or more sections are extensively connected to a metal, the heat capacity of which is greater than that of the reinforcing layer.

12. Method for the production of a high-temperature superconductor component according to one of the claims 1 to 11, in which the inside of a mold is lined with a metal sheet containing Ag, Au, Pt, Rh, Pd, Ru, Os, or IR, or a mixture of two or more thereof, and a melt of a material which, where appropriate after corresponding subsequent treatment, exhibits high-temperature superconductor properties, is applied to the mold.

13. Use of a high-temperature superconductor component according to one of the claims 1 to 11, or produced according to claim 12 as a current lead.

## Revendications

1. Composant supraconducteur à haute température ayant une aire de section supraconductrice à haute température d'au moins 1 mm² et présentant un segment conducteur, dans lequel le segment conducteur est relié à un conducteur de sécurité qui est configuré et disposé et en contact électriquement conducteur avec le segment conducteur et qui le recouvre au moins en partie dans une zone de sécurité et l'entoure au moins en partie de telle façon que le courant qui s'écoule dans la zone de sécurité du segment conducteur lors du passage du supraconducteur à haute température à la conduction normale est sensiblement complètement absorbé et transféré sans destruction dans cette zone de sécurité par le conducteur de sécurité pendant d'une durée d'au moins 1 seconde, la zone de sécurité représentant au moins 10% de la surface du segment conducteur, au moins une partie du segment conducteur étant complètement entourée sur son périmètre par le conducteur de sécurité.

2. Composant supraconducteur à haute température selon la revendication 1, **caractérisé par** une aire de section ronde, ovale ou polygonale, en particulier triangulaire, quadrangulaire, pentagonale ou hexagonale.

3. Composant supraconducteur à haute température selon la revendication 1 ou la revendication 2, **caractérisé en ce qu'**il est réalisé en forme de tube ou en forme de barreau.

4. Composant supraconducteur à haute température selon l'une des revendications 1 à 3, **caractérisé en ce que** le segment conducteur est en contact de manière conductrice continue et ininterrompue sur toute la surface avec le conducteur de sécurité sur au moins 10% de sa surface.

5. Composant supraconducteur à haute température selon l'une des revendications 1 à 4, **caractérisé en ce que** le conducteur de sécurité est un élément choisi dans le groupe constitué par Ag, Au, Pt, Rh, Pd, Ru, Os ou Ir ou deux ou plusieurs de ces métaux.

6. Composant supraconducteur à haute température selon l'une des revendications 1 à 5, **caractérisé en ce que** le conducteur de sécurité présente une épaisseur dans la plage de 20 µm à 800 µm.

7. Composant supraconducteur à haute température selon l'une des revendications 1 à 6, **caractérisé en ce que** l'on utilise comme matériau supraconducteur à haute température un matériau contenant les éléments Cu et O ainsi que Bi, Sr et Ca, ou Pb, Bi, Sr et Ca, ou Tl, Pb, Ba, Sr et Ca ou Hg, Ba et Ca ou Hg, Pb, Ba et Ca, ou RE et Ba, RE représentant les éléments Y, Nd, Sm, Eu, La, Gd, Dy, Ho, Er ou Yb ou un mélange de deux ou plusieurs d'entre eux.

8. Composant supraconducteur à haute température selon l'une des revendications 1 à 7, **caractérisé en ce qu'**il présente une couche de renfort en contact au moins par segments avec la surface du segment conducteur ou avec la surface du conducteur de sécurité ou bien avec les deux surfaces.

9. Composant supraconducteur à haute température selon la revendication 8, **caractérisé en ce que** la couche de renfort est une couche métallique d'une épaisseur de 40 µm à 10 mm.

10. Composant supraconducteur à haute température selon la revendication 8 ou 9, **caractérisé en ce que** la couche de renfort contient du Cu, Fe, Ni ou Ag.

11. Composant supraconducteur à haute température selon l'une des revendications 8 à 10, **caractérisé en ce qu'**un ou plusieurs segments sont en liaison sur le périmètre de la couche de renfort avec un métal dont la capacité calorifique est supérieure à la capacité calorifique de la couche de renfort.

12. Procédé de fabrication d'un composant supraconducteur à haute température selon l'une des revendications 1 à 11, dans lequel la face interne d'un moule de coulée est doublée d'une tôle contenant de l'Ag, Au, Pt, Rh, Pd, Ru, Os ou Ir ou un mélange de deux ou plusieurs de ces métaux et le moule de coulée est ensuite rempli d'une fusion d'un matériau qui, le cas échéant après un retraitement correspondant, présente des propriétés supraconductrices à haute température.

13. Utilisation d'un composant supraconducteur à haute température selon l'une des revendications 1 à 11 ou fabriqué selon la revendication 12 comme alimentation de courant.
